Europäisches Patentamt

European Patent Office

Office européen des brevets

(19)

(11) **EP 0 795 959 B1**

(12) **EUROPÄISCHE PATENTSCHRIFT**

(45) Veröffentlichungstag und Bekanntmachung des Hinweises auf die Patenterteilung:
**04.12.2002 Patentblatt 2002/49**

(51) Int Cl.$^7$: **H03H 17/02**

(21) Anmeldenummer: **96103787.6**

(22) Anmeldetag: **11.03.1996**

(54) **Asymmetrische Filterkombination für ein digitales Übertragungssystem**

Asymmetric filter combination for a digital transmission system

Combinaison disymmétrique de filtres pour un système de transmission numérique

(84) Benannte Vertragsstaaten:
**DE FR GB IT NL**

(43) Veröffentlichungstag der Anmeldung:
**17.09.1997 Patentblatt 1997/38**

(73) Patentinhaber: **Micronas GmbH**
**79108 Freiburg (DE)**

(72) Erfinder:
• **Temerinac, Miodrag, Prof.Dr.-Ing.**
**79194 Gundelfingen (DE)**

• **Witte, Franz-Otto, Dr.**
**79312 Emmendingen (DE)**

(56) Entgegenhaltungen:
**EP-A- 0 263 687**     **EP-A- 0 660 321**

• **PATENT ABSTRACTS OF JAPAN vol. 006, no. 160 (E-126), 21.August 1982 & JP-A-57 079725 (VICTOR CO OF JAPAN LTD), 19.Mai 1982,**

**Beschreibung**

Die Erfindung betrifft eine asymmetrische Filterkombination für die Übertragung eines binären Datenstroms auf einer digitalen Übertragungsstrecke, die einen Sender und mindestens einen Empfänger miteinander verbindet. Bei der digital übertragenen Information kann es sich um beliebige Signale, also Video, -Audio- oder sonstige Signale handeln. Von dem Inhalt ist selbstverständlich die jeweilige Datenrate $fs$ oder Symbolrate $fsymb$ abhängig. Wenn mehrere Bit des Datenstroms zu einem neuen Wert zusammengefaßt sind, dann spricht man von einem "Symbol". Die übertragene Information, beispielsweise für ein digitales Rundfunksystem besteht letzen Endes aus einer Bitfolge, die durch Binärwerte "0" und "1" dargestellt wird und die mittels eines geeigneten Modulationsverfahrens auf einen Träger moduliert wird. Die erforderliche Übertragungsbandbreite definiert einen Kanal.

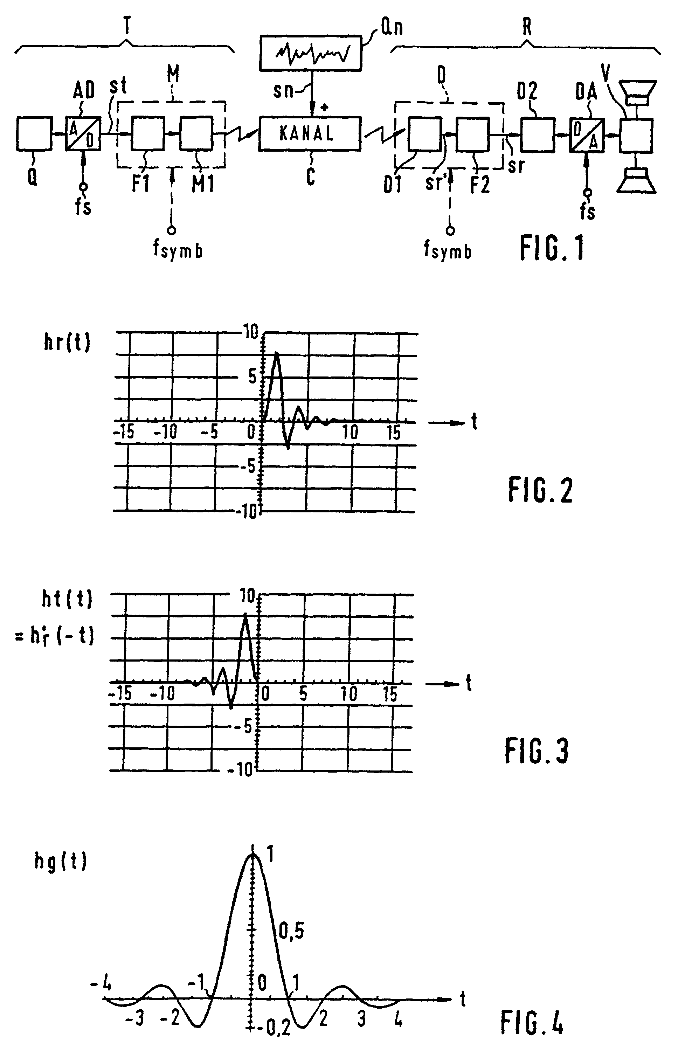

Theoretisch ist das Spektrum einer idealisierten Binärfolge unendlich breit, wenn die Impulsflanken dabei unendlich steil angenommen werden. Ein derartiges unbegrenztes Spektrum ist weder real noch kann es verarbeitet oder über einen begrenzten Kanal übertragen werden. Um die Bandbreite des erforderlichen Kanals und die zugehörigen Modulations- und Demodulationseinrichtungen nicht unnötig breitbandig auszubilden, ist es erforderlich, vor der Modulation die binäre Impulsfolge mit Hilfe von Impulsformfiltern in der Bandbreite zu begrenzen. Dabei sollten bestimmte, aus der Theorie der Signalübertragung bekannte Eigenschaften durch die Impulsformfilter erfüllt sein. Ein wesentliches Kriterium hierbei ist das Nyquistkriterium zur Eliminierung von Interferenzen zwischen benachbarten Daten oder Symbolen. Es wird dadurch erreicht, daß die zugehörige Übertragungsfunktion bei allen Periodenvielfachen des Abtasttaktes oder des Symboltaktes den Wert 0 aufweist, vgl. beispielsweise Fig. 4. Ein weiteres wichtiges Kriterium ist die sogenannte Rauschanpassungsbedingung, die durch angepaßte Filter (= matched filter) erfüllt wird. Filterkombinationen, die dieses Kriterium erfüllen, unterdrücken in einem Höchstmaß Rauschen, das zwischen diesen Filtern, also auf dem Übertragungskanal, dem Signal überlagert wird. Ein weiteres Kriterium ist eine ausreichende Signaldämpfung im Sperrbandbereich. Bei der beschriebenen Anwendung eines Datenübertragungssystems wird das Impulsformfilter in zwei Komponenten separiert, von denen die eine Komponente bei der Datenquelle, also im Sender, und die andere bei der Datensenke, also im Empfänger, plaziert wird.

Das Modulationsverfahren für die zu übertragende Datenfolge kann ein beliebiges digitales Modulationsverfahren sein, z.B. eine Phasenmodulation, eine Quadratur-Amplitudenmodulation, eine Frequenzmodulation oder eine beliebige andere Modulation. In der Regel wird die Datenfolge direkt oder kodiert mittels eines Trägers in ein Hochfrequenzband für die eigentliche Übertragung umgesetzt. Auf der Empfängerseite findet dann die entsprechende Umsetzung in das Basisband wieder statt, und durch die passenden Dekodiereinrichtungen wird die ursprüngliche Datenfolge wieder hergestellt, vgl. Fig. 1.

Bei den bisher üblichen digitalen Übertragungssystemen wird auf der Sender- und Empfängerseite der gleiche Aufwand für die Realisierung der Impulsformfilter getrieben. Dies ist für bidirektionale Übertragungsstrecken sinnvoll, bei Rundfunkübertragungsverfahren ist es jedoch zweckmäßig, den Aufwand auf der Empfängerseite möglichst klein zu halten und dafür lieber einen erhöhten Aufwand auf der Senderseite in Kauf zu nehmen.

Ein Beispiel für eine asymmetrische Filterkombination auf Sender- und Empfängerseite für eine Punkt-zu-Punkt Übertragungsstrecke ist in EP 0 263 687 A2 beschrieben. Für die nach dem Spreizspektrumverfahren in beiden Richtungen zu übertragenden Daten befindet sich auf der Senderseite ein PIR-Filter und auf der Empfängerseite ein IIR-Filter, dessen Charakteristik invers zur Charakteristik des senderseitigen FIR-Filters und damit von gleicher Ordnung ist.

Der Erfindung liegt die Aufgabe zugrunde, den Filteraufwand im Demodulator des Empfängers zu reduzieren und das dazugehörige Filter für den Modulator im Sender anzugeben, wobei die beschriebenen Kriterien für Impulsformfilter erfüllt sein sollen. Daneben sollen die angegebenen Impulsformfilter eine digitale Realisierung ermöglichen.

Die Aufgabe wird entsprechend dem Wortlaut des Anspruchs 1 durch eine asymmetrische Filterkombination gelöst.

Der Lösungsansatz geht von einer aufwandreduzierten Realisation des Empfängerfilters aus und das zugehörige Filter auf der Senderseite wird anschließend den Übertragungseigenschaften des Empfängerfilters angepaßt. Durch die Verwendung von Allpaßfiltern wird auf der Empfängerseite der Filteraufwand im Vergleich zu FIR-Filtern, beispielsweise "raised cosine"- oder Gauss-Filtern, erheblich reduziert. Die Realisierung des konjugiert komplexen Filters auf der Senderseite ist leider nicht mit Allpässen möglich, weil diese mit den geforderten Eigenschaften weder stabil noch kausal realisierbar sind. Es ist jedoch leicht möglich, durch eine FIR-Näherung ein Senderfilter zu entwerfen, das die geforderten Bedingungen mit beliebiger Genauigkeit erfüllt, wobei der Filteraufwand nur unwesentlich gegenüber dem bisheriger FIR-Filtern erhöht werden muß. Der Entwurf dieses Filters basiert auf der zeitgespiegelten und verzögerten Impulsantwort des Empfängerfilters und ist daher leicht bestimmbar.

Für die Empfängerseite lassen sich einfache Filterstrukturen angeben, die im wesentlichen zwei parallelgeschaltete Allpässe enthalten, aus deren Ausgangssignal eine Summe gebildet wird. Dabei läßt sich jeder Allpaß mit geringem Schaltungsaufwand realisieren, denn er erfordert nur einen Multiplizierer, drei Addierer/Subtrahierer und eine Verzögerungseinheit um zwei Takte.

Die Erfindung und vorteilhafte Ausgestaltungen werden nun anhand der Figuren der Zeichnung näher erläutert:

Fig. 1 zeigt schematisch die wesentlichen Funktionseinheiten eines digitalen Übertragungssystems, das mit einer asymmetrischen Filterkombination nach der Erfindung ausgestattet sein kann,

Fig. 2 zeigt im Zeitdiagramm ein Beispiel für die Übertragungsfunktion des Empfängerfilters nach der Erfindung,

Fig. 3 zeigt im Zeitdiagramm die Übertragungsfunktion des zugehörigen Senderfilters nach der Erfindung,

Fig. 4 zeigt im Zeitdiagrammm die gefaltete Übertragungsfunktion des Sender- und Empfängerfilters,

Fig. 5 zeigt im Frequenzdiagramm den Dämpfungsverlauf des Empfängerfilters und des zugehörigen idealen Senderfilters,

Fig. 6 zeigt den Dämpfungsverlauf des realen Senderfilters,

Fig. 7 zeigt schematisch als Augendiagramm die Grenzkurven des Binärdatenstroms im Empfänger.

Fig. 8 zeigt eine IIR-Filterstruktur und Fig. 9 zeigt eine Allpaßfilterstruktur.

In Fig. 1 ist schematisch ein digitales Übertragungssystem zwischen einem Sender T und einem Empfänger R dargestellt. Zwischen dem Sender und dem Empfänger befindet sich ein Übertragungskanal C, dem ein Störsignal sn aus einer beliebigen Rauschquelle Qn überlagert wird. Im Sender T befindet sich eine Signalquelle Q, deren Ausgangssignal in irgendeiner Form mittels eines Analog/Digitalumsetzers AD in einen Binärdatenstrom st mit der Datenrate fs umgesetzt wird, der einem Modulator M zugeführt ist. Vor der eigentlichen Modulationseinrichtung M1, die auch die Hochfrequenzumsetzung bewirkt, wird der Binärdatenstrom st mittels eines ersten Filters F1 gefiltert, das als Impulsformfilter im Sender T dient.

Auf der Empfängerseite wird das hochfrequent empfangene Signal in einem Demodulator D wieder in das Basisband oder ein tiefes Frequenzband gesetzt. Die eigentliche Hochfrequenzumsetzung findet in einer Demodulationseinrichtung D1 statt, deren Ausgang wieder einen digitalen Datenstrom sr' liefert, der mittels eines zweiten Filters F2 gefiltert wird. Dabei wirken das erste und zweite Filter F1, F2 als ein optimales Impulsformfilter zusammen, das sowohl das Nyquist-Kriterium als auch das Rauschanpassungskriterium erfüllt. Selbstverständlich wird dabei auch die erforderliche Dämpfung im Sperrbandbereich eingehalten. Das jeweilige Kodierungsund/oder Modulationsverfahren im Modulator M ist für die Erfindung unwesentlich, sofern die Übertragung im Kanal C eine Bitfolge darstellt. Die Bitfolge im Kanal C kann sich selbstverständlich von der Bitfolge des Binärdatenstroms st unterscheiden, das hängt von dem jeweiligen Kodierungsverfahren und einer dabei verwendeten Redundanzerhöhung ab. Wenn einige Stellen des Binärdatenstromes st zu einem einzigen Wert zusammengefaßt werden, dann wird ein "Symbol"-Datenstrom mit der Symbolfrequenz $fsymb \leq fs$ übertragen. Im einfachsten Fall liefert der Ausgang des Demodulators D einen Binärdatenstrom sr, der dem senderseitigen Binärdatenstrom st gleich ist und mittels einer digitalen Signalverarbeitungseinrichtung D2 beliebig weiterverarbeitet wird. Deren Ausgangssignal wird beispielsweise mittels eines wieder mit dem Abtasttakt fs betriebenen Digital /Analog-Umsetzers DA in ein oder mehrere analoge Signale umgewandelt, die einem Verstärker V zugeführt sind, der beispielsweise mit zwei Lautsprechern für eine Stereowiedergabe gekoppelt ist.

Die schematische Darstellung von Fig. 1 ist sowohl mit einer symmetrischen als auch in vorteilhafter Weise mit einer asymmetrischen Filterkombination F1, F2 nach der Erfindung zu realisieren. Beispiele für die Impulsantwort h (t) einer asymmetrischen Filterkombination F1, F2 sind in Fig. 2 für das senderseitige Filter F1 und Fig. 3 für das empfängerseitige Filter F2 angegeben. Beide Zeitverläufe sind bezüglich der Zeitachse t = 0 zueinander spiegelsymmetrisch. Die sich in den negativen Zeitbereich erstreckende Impulsantwort von Fig. 3 ist durch eine entsprechende Vorverzögerung der Impulsantworten von Fig. 2 und Fig. 3 zu realisieren, ohne daß das Kausalitätsgesetz verletzt wird. Das Zusammenwirken der beiden asymmetrischen Filter F1, F2 wird durch die gemeinsame Impulsantwort hg (t) in Fig. 4 dargestellt, die sich aus der Faltung der Impulsantwort von Fig. 2 und Fig. 3 ergibt.

Für die weitere Betrachtung ist es erforderlich, daß das Nyquist- und das Rauschanpassungskriterium ausführlicher anhand der komplexen Übertragungsfunktionen H(z) betrachtet werden. In den folgenden Formeln wird eine Indizierung in der üblichen Form nur vorgenommen, wenn andernfalls Mißverständnisse entstehen könnten. Die Filterkombination F1, F2 hat eine gemeinsame Übertragungsfunktion Hg(z), die in eine Übertragungsfunktion Ht(z) für das Senderfilter und Hr(z) für das Empfängerfilter aufgeteilt ist. Aus der Faltung der beiden Teilfilter F1, F2 ergibt sich die Übertragungsfunktion Hg(z) für die Filterkombination F1, F2:

$$Hg(z) \: Ht(z) \times Hr(z), \qquad\qquad (Gleichung \: 1)$$

Für die weiteren Betrachtungen wird zunächst vorausgesetzt, daß die Signalabtastfrequenz fs, die beispielsweise durch den Analog/Digital-Umsetzer AD bestimmt wird, der doppelten Symbolrate fs = 2 x fsymb entspricht. Die Symbolrate ist niedriger als die Abtastfrequenz und ergibt sich aus der Zusammenfassung von M Bits des primären Datenstroms st zu einem einzigen Symbolwert, der letztendlich in irgendeiner Form kodiert übertragen wird und die Symbolfrequenz/Symbolrate auf der Übertragungsstrecke C bestimmt.

Unter der Annahme

$$fs = 2 \times fsymb \qquad\qquad (Gleichung \: 2)$$

wird die Realisierung der Impulsformfilter und die Formulierung der zu erfüllenden Kriterien besonders einfach, wie folgende Ausführungen zeigen. Dann hat das Nyquist-Kriterium folgende allgemeine Form:

$$Hg(z) + Hg(-z^*) = 1 \qquad\qquad (Gleichung \: 3)$$

wobei $z = Exp(j \times 2\pi \times f/f_S)$ ist und statt der Abtastfrequenz fs auch die Symbolfrequenz fsymb der Frequenznormierung dienen kann.

Für eine optimale Rauschanpassung muß zwischen dem ersten und zweiten Filter F1, F2 folgende Beziehung bestehen:

$$Ht(z) = Hr(z^*) \qquad\qquad (Gleichung \: 4)$$

Des weiteren ist zur Unterdrückung von Nachbarkanalstörungen im jeweiligen Sperrbandbereich von F1, F2 eine ausreichende Dämpfung $a_{min}$ gefordert. Der Beginn des Sperrbandes wird gemäß den Gleichungen 5 und 6 üblicherweise mit Hilfe des "Roll-off"-Faktors r definiert:

$$Ht(Exp(j \times 2\pi \times f/f_s)) \leq a_{min} \qquad mit \: f \geq 0{,}5 \times fsymb \times (1 + r) \qquad\qquad (Gleichung \: 5)$$

$$Hr(Exp(j \times 2\pi \times f/f_s)) \leq a_{min} \qquad mit \: f \geq 0{,}5 \times fsymb \times (1 + r) \qquad\qquad (Gleichung \: 6)$$

Diese Bedingungen werden wie bereits angegeben durch die als Impulsformfilter weithin eingesetzten "raised-cosin"- und Gauss-Filter erfüllt. Der Nachteil dieser Filterstrukturen ist jedoch der beträchtliche Aufwand auf der Sender- und Empfängerseite.

Der Erfindung liegt die Erkenntnis zugrunde, daß eine Empfänger-Filterstruktur mit zwei parallelgeschalteten Allpässen A1, A2 ebenfalls die Kriterien gemäß den Gleichungen 2, 3, 5 und 6 erfüllen kann. Die zugehörige komplexe Übertragungsfunktion hat das folgende Aussehen:

$$Hr(z) = 1/2 \times (A1(z^2) + z^{-1} \times A2(z^2)) \qquad\qquad (Gleichung \: 7)$$

wobei die komplexe Variable z in den Übertragungsfunktionen der beiden Allpässe A1, A2 gegenüber der allgemeinen Allpaß-Übertragungsfunktion $A_i(z)$ durch $z^2$ substituiert ist. Die Exponenten von z sind somit ganzzahlig.

Die komplexe Übertragungsfunktion für allgemeine Allpässe ist:

$$H_{Allpaß}(z) = A_i(z) = (a_m + a_{m-1} \times z^{-1} + ... + z^{-m})/(1 + a_1 \times z^{-1} + ... + a_m \times z^{-m}) \qquad\qquad (Gleichung \: 8)$$

Wird die Gleichung 8 anstatt auf die Variable z auf die invertierte Variable $z^* = 1/z$ bezogen, dann ergibt sich folgende Umformung für die Gleichung 8:

$$A_i(z^*) = 1 / A_i(1/z) \qquad \text{(Gleichung 8A)}$$

Wie sich nachweisen läßt, erfüllt eine Filterkombination F1, F2, die sowohl im Empfängerfilter F2 als auch im entsprechenden Senderfilter F1 mittels Allpässen realisiert ist, theoretisch die geforderte Nyquist-Bedingung.

Ausgehend von Gleichung 7 wird über die Rauschanpassungsbedingung von Gleichung 4 aus der Übertragungsfunktion Hr(z) des Empfängerfilters F2 die zugehörige Übertragungsfunktion Ht(z) des Senderfilters F1 gebildet.

$$Ht(z) = 1/2 \times (1 / A1(z^2) + z / A2(z^2)) \qquad \text{(Gleichung 8b)}$$

Die gemeinsame Übertragungsfunktion Hg(z) dieser Filterkombination F1, F2 mit Allpässen gibt sich aus der Faltung der einzelnen Übertragungsfunktionen gemäß Gleichung 7 und Gleichung 8b:

$$Hg(z) = 1/2 \times (A1(z^2) + z^{-1} \times A2(z^2)) \times 1/2 \times (1/A1(z^2) + z/A2(z^2)) \qquad \text{(Gleichung 9)}$$

Die Faltung, die über eine komplexe Multiplikation der beiden Übertragungsfunktionen Hr(z) und Ht(z) durchzuführen ist, führt schließlich zur folgender Gleichung:

$$Hg(z) = 1/2 + 1/4 \times (z \times A1(z^2) / A2(z^2)) + z^{-1} \times A2(z^2) / A1(z^2)) \qquad \text{(Gleichung 10)}$$

Wendet man auf Gleichung 10 das Nyquist-Kriterium aus Gleichung 3 formal an, wobei insbesondere die Übertragungsfunktion Hg(-z*) zu bilden ist, dann ergibt sich schließlich

$$Hg(z) + Hg(-z^*) = 1+0 \qquad \text{(Gleichung 11)}$$

Obwohl die Gleichung 11 über die Übertragungsfunktionen von Filtern mit Allpässen hergeleitet ist, zeigt sie das gleiche Aussehen wie Gleichung 3, die ganz allgemein für das Nyquist-Kriterium steht. Leider ist das formal hergeleitete Senderfilter F1 als konjugiert komplexes Filter gemäß Gleichung 4 instabil und mit Allpässen in dieser Form kausal nicht realisierbar. Durch die Invertierung des als stabil vorausgesetzten Empfängerfilters F2 werden Pole und Nullstellen vertauscht, wodurch die Pole des Senderfilters F1 in der komplexen Frequenzebene außerhalb des Einheitskreises zu liegen kommen. Dies gilt jedoch nur für eine mathematisch exakte IIR-Realisierung des Sendefilters. Es ist jedoch leicht möglich, durch eine FIR-Näherung ein Sendefilter zu entwerfen, das die geforderten Bedingungen mit einer nur durch den Filteraufwand begrenzten Genauigkeit erfüllt. Der Entwurf dieses Filters basiert wie bereits angegeben auf der zeitgespiegelten und verzögerten Impulsantwort hr'(-t) = ht(t) des Empfängerfilters F2 entsprechend Fig. 2 und Fig. 3.

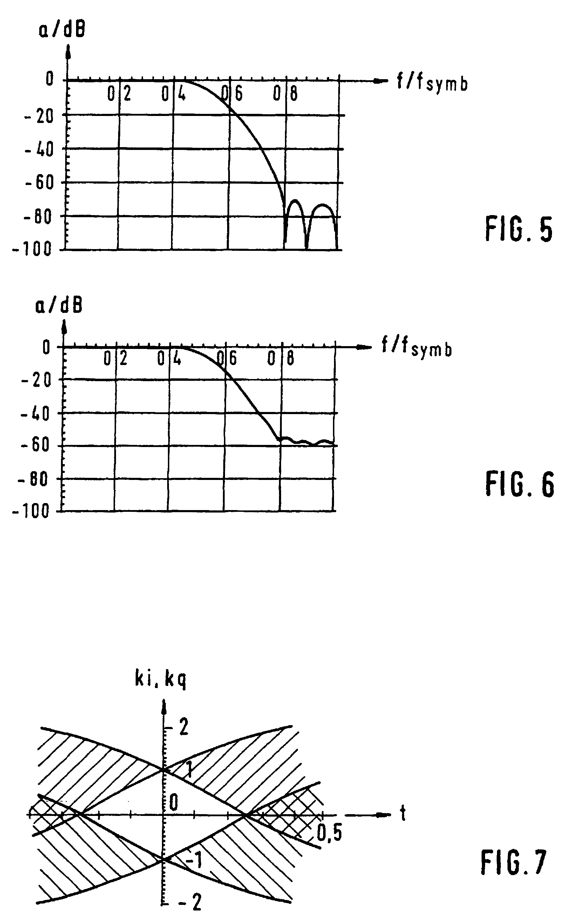

In Fig. 5 ist beispielsweise der Dämpfungsverlauf eines Empfängerfilters F2 mit Allpässen dargestellt. Die Frequenz f ist dabei auf die Symbolfrequenz fsymb normiert. Im Sperrbandbereich beträgt die Dämpfung a etwa -70 db. Das konjugiert komplexe Empfängerfilter, vgl. Gleichung 8b, müßte theoretisch den gleichen Dämpfungsverlauf aufweisen. Da wie bereits angegeben eine Allpaßrealisierung dort jedoch nicht möglich ist, wird als Senderfilter F1 eine FIR-Filterstruktur verwendet, mit der die zu spiegelnde Impulsantwort hr(t) durch die Impulsantwort ht(t) von Fig. 3 möglichst gut angenährt wird. Dabei muß die Impulsantwort, die sich theoretisch unendlich weit in den negativen Zeitbereich erstreckt, durch ein Zeitfenster ersetzt werden, das den zeitlichen Beginn der Impulsantwort festlegt. Dies ist voll gerechtfertigt, wenn die abgeschnittene Impulsantwort nur noch einen unbedeuteten Beitrag darstellt. Gegebenenfalls muß das Zeitfenster und die zugehörige FIR-Filterstruktur weiter vergrößert werden, bis der unterdrückte Beitrag vernachlässigbar wird. Eine Abschätzung gegenüber den bisher verwendeten FIR-Filtern F1 zeigt, daß nach der Erfindung der Filteraufwand dort lediglich um 10 bis 20 % vergrößert werden muß. Demgegenüber ist die Einsparung auf der Empfängerseite dramatisch, denn der vergleichbare Filteraufwand reduziert sich dort beispielsweise um den Faktor 10.

Der Einfluß des eine Näherung darstellenden FIR-Filters auf die Signalübertragungseigenschaften zeigt sich im wesentlichen nur in der Sperrbanddämpfung, die in dem angenommen Beispiel von Fig. 6 etwa bei -55 dB liegt, das ist aber ein Wert, der für das gewünschte Dämpfungsverhalten mehr als ausreichend ist.

In Fig. 7 ist schematisch für eine QPSK-Modulation das Augendiagramm des empfängerseitigen Inphase- oder Quadraturphasen-Datenstromes sr dargestellt. Die zum Zeitpunkt t = 0 durch die Signalwerte sr = +1 und = -1 gehenden Kurven stellen Grenzkurven dar, zwischen denen sich das empfängerseitige Binärsignal sr aufhalten kann. Dies ist unabhängig davon, ob gerade ein Symbolübergang stattfindet oder nicht. Da sich diese Grenzkurven exakt bei den Werten +1 und -1 schneiden, ist ersichtlich, daß die Folge der vorausgehenden Symbole beliebig sein kann und keinerlei Einfluß auf den zum Zeitpunkt t = 0 zu bestimmenden Symbolzustand sr hat. Das Augendiagramm von Fig. 7 ist rechnerisch aus einer asymmetrischen Filterkombination F1, F2 bestimmt, deren Dämpfungsverlauf Fig. 5 und Fig. 6 entspricht.

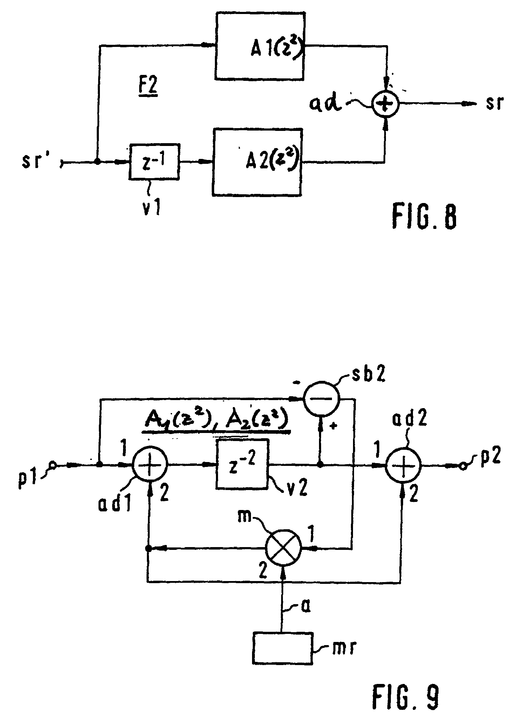

In Fig. 8 ist schematisch die Filterstruktur des Empfängerfilters F2 mit zwei Allpässen dargestellt. Die Struktur zeigt einen ersten Signalzweig mit dem Allpaß $A1(z^2)$ und einen zweiten Signalzweig mit einer Serienschaltung aus einem $z^{-1}$-Verzögerer v1 und dem zweiten Allpaß $A2(z^2)$. Der Eingang der beiden Signalzweige ist gemeinsam mit einem digitalen Eingangssignal sr' gespeist. Der Ausgang des ersten Allpasses $A1(z^2)$ und der Ausgang des zweiten Allpasses $A2(z^2)$ sind jeweils mit dem Eingang eines Addierers ad verbunden, dessen Ausgang das digitale Ausgangssignal sr des Empfängerfilters F2 liefert.

In Fig. 9 sind schematisch die Funktionseinheiten und die zugehörige Struktur eines für die Erfindung geeigneten Allpasses Ai dargestellt. Ein Eingang p1 ist mit dem ersten Eingang eines ersten Addierers ad1 und mit dem Subtrahendeingang eines Subtrahierers sb2 verbunden. Der Ausgang des Addierers ad2 liegt an einem $z^{-2}$-Verzögerer v2, dessen Ausgang mit dem Minuendeingang des Subtrahierers sb2 und dem ersten Eingang eines zweiten Addierers ad2 verbunden ist. Am Ausgang des Subtrahierers sb2 ist der erste Eingang 1 eines Multiplizierers m angeschlosssen, dessen zweiter Eingang 2 mit einem Faktor a aus einer Speichereinrichtung mr gespeist ist. Mit dem Faktor a werden die Filtereigenschaften des Allpasses $A1(z^2)$ bzw $A2(z^2)$ bestimmt. Der Ausgang des Multiplizierers m ist sowohl mit einem zweiten Eingang 2 des ersten Addierers ad1 als auch einem zweiten Eingang 2 des zweiten Addierers ad2 verbunden, dessen Ausgang an einen Ausgang p2 angeschlossen ist. Die Filterstruktur ist damit sehr einfach und läßt sich leicht digital realisieren. Es wird darauf hingewiesen, daß die Allpaßstruktur nach Fig. 9 lediglich einen einzigen Multiplizierer m aufweist. Dem gegenüber enthalten die bisherigen FIR-Strukturen für das Empfängerfilter F2 eine Vielzahl von Multiplizierern, mit denen die einzelnen Gewichtungen der gespeicherten Signale durchzuführen sind. Unter Umständen müssen dort bis zu 40 Abtastwerte gewichtet und damit multipliziert werden. Der Vorteil einer Empfängerrealisierung mit Allpaßfiltern ist aus diesem Vergleich sofort ersichtlich. Eine digitale Realisierung des Empfängerfilters F2 oder des Sendefilters F1 ist indessen nicht zwingend, da die erfinderische Idee auch auf analoge Filterstrukturen angewendet werden kann.

**Patentansprüche**

1. Asymmetrische Filterkombination (F1, F2) für die Übertragung eines Binärdatenstromes (st) zwischen einem Sender (T) und einem Empfänger (R) mit

   - einem eine FIR-Struktur aufweisenden ersten Filter (F1) auf der Senderseite und

   - einem eine IIR-Struktur aufweisenden zweiten Filter (F2) auf der Empfängerseite, wobei

   - die Kombination aus dem ersten und zweiten Filter (F1, F2) einer gemeinsamen Übertragungsfunktion $H_g(z)$ = $H_t(z) \times H_r(z)$ entspricht,

   **gekennzeichnet durch** folgende Merkmale:

   - das zweite Filter (F2) enthält einen ersten und zweiten Allpaß ($A1(z^2)$, $A2(z^2)$) und hat die Übertragungsfunktion

$$H_r(z) = \frac{1}{2} \cdot \left( A_1(z^2) + z^{-1} \cdot A_2(z^2) \right),$$

   - die Ordung des zweiten Filters (F2) ist kleiner als die Ordnung des ersten Filters (F1),

   - die gemeinsame Übertragungsfunktion $H_g(z)$ = $H_t(z) \times H_r(z)$ erfüllt sowohl das Nyquistkriterium $H_g(z) + H_g(-z^*)$ = als auch das Rauschanpassungskriterium $H_t(z) = H_r(z^*)$,

2. Filterkombination nach Anspruch 1, **dadurch gekennzeichnet, daß** die Übertragungsfunktion $H_t(z)$ des ersten

Filters (F1) über die Symmetriebedingung des Rauschanpassungs-Kriteriums $H_t(z) = H_r(z^*)$ bezüglich der Impulsantworten $h_t(t)$, $h_r(t)$ des ersten und zweiten Filters (F1, F2) aus der Übertragungsfunktion $H_r(z)$ des zweiten Filters (F2) bestimmt ist, und die resultierende Impulsantwort $h_t(t)$ des ersten Filters (F1) durch eine FIR-Struktur beliebig genau an die durch die Symmetriebedingung vorgegebene Impulsantwort angenähert ist.

3. Filterkombination nach Anspruch 1 oder 2, **dadurch gekennzeichnet, daß** das zweite Filter (F2) zwei parallele Signalzweige aufweist, die eingangsseitig miteinander verbunden sind und ausgangsseitig mittels eines Addierers (ad) zusammengeschaltet sind, wobei der erste Signalzweig den ersten Allpaß ($A1(z^2)$) und der zweite Signalzweig eine Serienschaltung aus einem $z^{-1}$-Verzögerer (v1 und dem zweiten Allpaß ($A2(z^2)$) enthält.

4. Filterkombination nach einem der Ansprüche 1 bis 3, **dadurch gekennzeichnet, daß** der erste und zweite Allpaß ($A1(z^2)$, $A2(z^2)$) jeweils eine Allpaßstruktur erster Ordnung darstellt, die als Funktionseinheiten einen $z^2$-Verzögerer (v2), einen Multiplizierer (m), einen ersten und zweiten Addierer (ad1, ad2) und einen zweiten Subtrahierer (sb2) enthält.

5. Filterkombination nach Anspruch 4, **dadurch gekennzeichnet, daß** die Funktionseinheiten im ersten bzw. zweiten Allpaß ($A_1(z^2)$) bzw. ($A_2(z^2)$) wie folgt miteinander verbunden sind:

- eine Serienschaltung zwischen einem Eingang (p1) und einem Ausgang (p2) enthält in Signalflußrichtung den am ersten Eingang (1) angeschlossenen ersten Addierer (ad1), den $z^2$-Verzögerer (v2) und den am ersten Eingang (1) angeschlossenen zweiten Addierer (ad2),

- der zweite Subtrahierer (sb2) ist über seinen Subtrahendeingang mit dem Eingangsanschluß (p1), über seinen Minuendeingang mit dem Ausgang des $z^2$-Verzögerers (v2) und über seinen Ausgang mit dem ersten (1) Eingang des Multiplizierers (m) verbunden, und

- der zweite Eingang (2) des Multiplizierers (m) ist aus einem Speicher (mr) mit einem Filterfaktor a gespeist und der Ausgang des Multiplizierers (m) ist sowohl mit dem zweiten Eingang (2) des ersten Addierers (ad1) als auch mit dem zweiten Eingang (2) des zweiten Addierers (ad2) verbunden.

6. Verfahren zur Dimensionierung einer asymmetrischen Filterkombination (F1, F2) für die Übertragung eines binären Datenstromes von einem Sender (T) auf einen Empfänger (R), wobei die Filterkombination auf der Senderseite ein erstes Filter (F1) mit einer FIR- und auf der Empfängerseite ein zweites Filter (F2) mit einer IIR-Struktur enthält,

- in einem ersten Verfahrensschritt wird das zweite Filter (F2) entsprechend der Übertragungsfunktion

$$H_r(z) = \frac{1}{2} \cdot \left( A_1(z^2) + z^{-1} \cdot A_2(z^2) \right)$$

mit einem $z^{-1}$-Verzögerer (v1) und einem ersten und zweiten Allpaß ($A1(z^2)$, $A2(z^2)$) dimensioniert,

- in einem zweiten Verfahrensschritt wird die Impulsantwort $h_r(t)$ des zweiten Filters (F2) bestimmt,

- in einem dritten Verfahrensschritt wird aus der Impulsantwort $h_r(t)$ des zweiten Filters (F2) entsprechend dem Rauschanpassungs-Kriterium $H_t(z) = H_r(z^*)$ eine zeitlich gespiegelte Impulsantwort $h_r'(-t) = h_t(t)$ gebildet, wobei die Impulsantwort $h_r(t)$ im Bereich geringfügiger, insbesondere auslaufender, Restschwingungen zuvor zeitlich begrenzt wird, und

- in einem vierten Verfahrensschritt werden aus der zeitlich gespiegelten und zeitlich begrenzten Impulsantwort $h_t(t)$ die Filterkoeffizienten ($a_0$ bis $a_n$) eines FIR-Filters bestimmt, das in der Filterkombination (F1, F2) als erstes Filter (F1) dient.

**Claims**

1. An asymmetric filter combination (F1, F2) for the transmission of a binary data stream (st) between a transmitter (T) and a receiver (R), comprising:

- a first filter (FI) at the transmitter end, having an FIR structure; and

- a second filter (F2) at the receiver end, having an IIR structure, with

- the combination of the first and second filters (F1, F2) yielding a common transfer function $H_g(z) = H_t(z) \times H_r(z)$,

**characterized by** the following features:

- the second filter (F2) comprises a first and a second all-pass network ($A1(z^2)$, $A2(z^2)$) and has the transfer function

$$H_r(z) = \frac{1}{2} \cdot \left( A_1(z^2) + z^{-1} \cdot A_2(z^2) \right);$$

- the order of the second filter (F2) is lower than the order of the first filter (F1); and

- the common transfer function $H_g(z)=H_t(z)\times H_r(z)$ satisfies both the Nyquist criterion $H_g(z)+H_g(-z^*)=1$ and the noise-matching criterion $H_t(z)=H_r(z^*)$.

2. A filter combination as set forth in claim 1, **characterized in that** the transfer function $H_t(z)$ of the first filter (F1) is determined from the transfer function $H_r(z)$ of the second filter (F2), particularly via the symmetry condition of the noise-matching criterion $H_t(z) = H_r(z^*)$ with respect to the impulse responses $h_t(t)$, $h_r(t)$ of the first and second filters (F1, F2), and that the resulting impulse response $h_t(t)$ of the first filter (F1) is approximated with arbitrary accuracy by an FIR structure.

3. A filter combination as set forth in claim 1 or 2, **characterized in that** the second filter (F2) has two parallel signal paths which are connected together at the input end, and which are connected together at the output end by means of an adder (ad), with the first signal path containing the first all-pass network ($A1(z^2)$), and the second signal path containing a series combination of a $z^{-1}$ delay element (v1) and the second all-pass network ($A2(z^2)$).

4. A filter combination as set forth in any one of claims 1 to 3, **characterized in that** the first and second all-pass networks ($A1(z^2)$, $A2(z^2)$) each represent a first-order all-pass structure which contains a $z^{-2}$ delay element (v2), a multiplier (m), a first adder (ad1), a second adder (ad2), and a second subtracter (sb2) as functional units.

5. A filter combination as set forth in claim 4, **characterized in that** the functional units in the first and second all-pass networks ($A1(z^2)$, $A2(z^2)$) are interconnected as follows:

- a series combination between an input (p1) and an output (p2) contains, in the direction of signal flow, the first adder (ad1), which has its first input (1) connected to the input (p1), as well as the $z^{-2}$ delay element (v2) and the second adder (ad2), which has its first input (1) connected to the output of the $z^{-2}$ delay element (v2);

- the second subtracter (sb2) is connected to the input terminal (p1) via its subtrahend input, to the output of the $z^{-2}$ delay element (v2) via its minuend input, and to the first input (1) of the multiplier (m) via its output; and

- the second input (2) of the multiplier (m) is fed with a filter factor a from a memory (mr), and the output of the multiplier (m) is connected both to the second input (2) of the first adder (ad1) and to the second input (2) of the second adder (ad2).

6. A method of designing an asymmetric filter combination (F1, F2) for the transmission of a binary data stream from a transmitter (T) to a receiver (R), the filter combination comprising a first filter (F1) with an FIR structure at the transmitter end and a second filter (F2) with an IIR structure at the receiver end, wherein:

- in a first step, the second filter (F2) is designed according to the transfer function

$$H_r(z) = \frac{1}{2} \cdot \left( A_1(z^2) + z^{-1} \cdot A_2(z^2) \right)$$

using a $z^{-1}$ delay element (v1) as well as a first and a second all-pass network (A1($z^2$), A2($z^2$));

- in a second step, the impulse response $h_r(t)$ of the second filter (F2) is determined;

- in a third step, a-mirrored impulse response $h'_r(-t) = h_t(t)$ is formed from the impulse response $h_r(t)$ of the second filter (F2) according to the noise-matching criterion ($H_t(z) = H_r(z^*)$), with the impulse response $h_r(t)$ being previously bounded in time in the range of slight residual oscillations, particularly in the range of residual oscillations which are dying out; and

- in a fourth step, the coefficients ($a_0$ to $a_n$) of an FIR filter which serves as the first filter (F1) in the filter combination (F1, F2) are determined from the mirrored and bounded impulse response $h_t(t)$.

## Revendications

1. Combinaison asymétrique de filtres (F1, F2) pour la transmission d'un flux de données binaires (st) entre un émetteur (T) et un récepteur (R), comportant,

   - un premier filtre (F1) ayant une structure de filtre à réponse impulsionnelle finie (FIR) et disposé du côté de l'émetteur et
   - un deuxième filtre (F2) ayant une structure de filtre à réponse impulsionnelle infinie (IIR) et disposé du côté du récepteur,

   la combinaison des premier et deuxième filtres (F1, F2) correspondant à une fonction de transfert commune

   $$Hg(z) = H_t(z) \times H_r(z)$$

   **caractérisée par** les caractéristiques suivantes :

   - le deuxième filtre (F2) contient un premier et un deuxième filtre passe-tout (A1 ($z^2$), (A2 ($z^2$)),
   - l'ordre du deuxième filtre (F2) est plus petit que l'ordre du premier filtre (F1),
   - la fonction de transfert commune $H_g(z) = H_t(z) \times H_r(z)$ remplit aussi bien le critère de Nyquist $H_g(z) + H_g(-z^*)$ = 1 que le critère d'adaptation à un bruit minimum $H_t(z) = H_r(z^*)$.

2. Combinaison de filtres selon la revendication 1, **caractérisée en ce que** la fonction de transfert $H_t(z)$ du premier filtre (F1) est déterminée à partir de la fonction de transfert $H_r(z)$ du deuxième filtre (F2) par la condition de symétrie du critère d'adaptation à bruit minimum $H_t(z) = H_r(z^*)$ en ce qui concerne les réponses impulsionnelles ht(t) et $h_r$(t) du premier filtre (F1) et du deuxième filtre (F2) et **en ce que** la réponse impulsionnelle résultante $h_t(t)$ premier filtre (F1) est déterminée de manière approchée le plus exactement possible à la réponse impulsionnelle prédéterminée par la condition de symétrie, au moyen d'une structure de filtre FIR.

3. Combinaison de filtres selon la revendication 1 ou 2, **caractérisée en ce que** le deuxième filtre (F2) comporte deux branches de signaux parallèles qui sont reliées entre elles du côté de l'entrée et par l'intermédiaire d'un additionneur (ad) du côté de la sortie, la première branche de signaux contenant le premier filtre passe-tout (A1 ($z^2$)) et la deuxième branche de signaux contenant un circuit série constitué d'un retardateur $z^{-1}$ (v1) et le deuxième filtre passe-tout (A2($z^2$)).

4. Combinaison de filtres selon l'une quelconque des revendications 1 à 3, **caractérisée en ce que** le premier filtre passe-tout (A1($z^2$)) et le deuxième filtre passe-tout (A2($z^2$)) représentent chacun une structure de filtre passe-tout du premier ordre qui contient un retardateur $z^{-2}$ (v2), un multiplicateur (m), un premier et un deuxième additionneurs (ad1, ad2) et un soustracteur (sb2).

5. Combinaison de filtres selon la revendication 4, **caractérisée en ce que** les unités fonctionnelles du premier filtre passe-tout (A1($z^2$)) ou du deuxième filtre passe-tout (A2($z^2$)) sont reliées entre elles de la manière suivante :

- un circuit série disposé entre une entrée (p1) et une sortie (p2) comprend, dans le sens du flux de signaux, le premier additionneur (ad1), qui est branché par sa première entrée (1), le retardateur $z^{-2}$ (v2) et le deuxième additionneur (ad2), qui est branché par sa première entrée (1),
- le soustracteur (sb2) est relié, par l'intermédiaire de son entrée de soustraction, à la connexion d'entrée (p1), par l'intermédiaire de son entrée de diminuende, à la sortie du retardateur $z^{-2}$ (v2) et par l'intermédiaire de sa sortie, à la première entrée (1) du multiplicateur (m), et
- la deuxième entrée (2) du multiplicateur (m) est alimenté à partir d'une mémoire (mr) ayant un facteur de filtre a et la sortie du multiplicateur (m) est reliée aussi bien à la deuxième entrée (2) du premier additionneur (ad1) qu'à la deuxième entrée (2) du deuxième additionneur (ad2).

6. Procédé pour le dimensionnement d'une combinaison asymétrique de filtres (F1, F2) pour la transmission d'un flux de données binaires (st) allant d'un émetteur (T) à un récepteur (R), la combinaison de filtres comportant, du côté de l'émetteur, un premier filtre (F1) ayant une structure de filtre à réponse impulsionnelle finie (FIR) et, du côté du récepteur, un deuxième filtre (F2) ayant une structure de filtre à réponse impulsionnelle infinie (IIR), comportant les étapes suivantes :

- pendant une première étape de procédé, on dimensionne le deuxième filtre (F2) en correspondance avec la fonction de transfert :

$$H_r(z) = 1/2 \cdot (A_1(z^2) + z^{-1} \cdot A^2(z^2))$$

avec un retardateur $z^{-1}$ (v1) et un premier et un deuxième filtres passe-tout (A1($z^2$), A2($z^2$)),
- pendant une deuxième étape de procédé, on détermine la réponse impulsionnelle $h_r(t)$ du deuxième filtre (F2),
- pendant une troisième étape de procédé, on forme, à partir de la réponse impulsionnelle $h_r(t)$ du deuxième filtre (F2), en correspondance avec le critère d'adaptation à bruit minimum $H_t(z) = H_r(z^*)$, une réponse impulsionnelle réfléchie dans le temps $h_r'(-t) = h_t(t)$, la réponse impulsionnelle $h_r(t)$ étant, auparavant, (imitée dans le temps dans la zone d'oscillations résiduelles insignifiantes, en particulier en cours d'arrêt, et
- pendant une quatrième étape de procédé, on détermine, à partir de la réponse impulsionnelle hr(t) réfléchie dans le temps et limitée dans le temps, les coefficients de filtre (a0 à an) d'un filtre à réponse impulsionnelle finie qui sert de premier filtre (F1) dans la combinaison de filtres (F1, F2).

FIG.1

FIG.2

FIG.3

FIG.4

11

FIG. 5

FIG. 6

FIG. 7

FIG. 8

FIG. 9